# EUROPÄISCHE PATENTSCHRIFT

(11) **EP 1 512 175 B1**
(45) Veröffentlichungstag und Bekanntmachung des Hinweises auf die Patenterteilung: **08.02.2017**
(21) Anmeldenummer: 03740024.9
(22) Anmeldetag: 23.05.2003
(51) Int. Cl.: H01L 23/24, H01L 23/62

(54) **ELEKTRISCHES BAUELEMENT**
ELECTRICAL COMPONENT
COMPOSANT ELECTRIQUE

(30) Priorität: 24.05.2002 DE 10223322
(43) Veröffentlichungstag der Anmeldung: 09.03.2005
(73) Patentinhaber: ROBERT BOSCH GMBH, 70442 Stuttgart (DE)
(72) Erfinder: HAMSEN, Karin, 72762 Reutlingen (DE); URBACH, Peter, 72762 Reutlingen (DE); SPITZ, Richard, 72766 Reutlingen (DE)
(86) Internationale Anmeldenummer: PCT/DE2003/001674
(87) Internationale Veröffentlichungsnummer: WO 2003/100855

(56) Entgegenhaltungen:
- EP-A- 0 034 208
- EP-A- 0 936 670
- EP-A- 1 075 010
- DE-A- 4 341 269
- DE-A- 10 005 183
- DE-A- 19 549 202
- PATENT ABSTRACTS OF JAPAN Bd. 1996, Nr. 07, 31. Juli 1996 (1996-07-31) & JP 8 078611 A (NEC CORP), 22. März 1996 (1996-03-22) -& JP 08 078611 A (NEC CORP) 22. März 1996 (1996-03-22)

## Beschreibung

### Stand der Technik

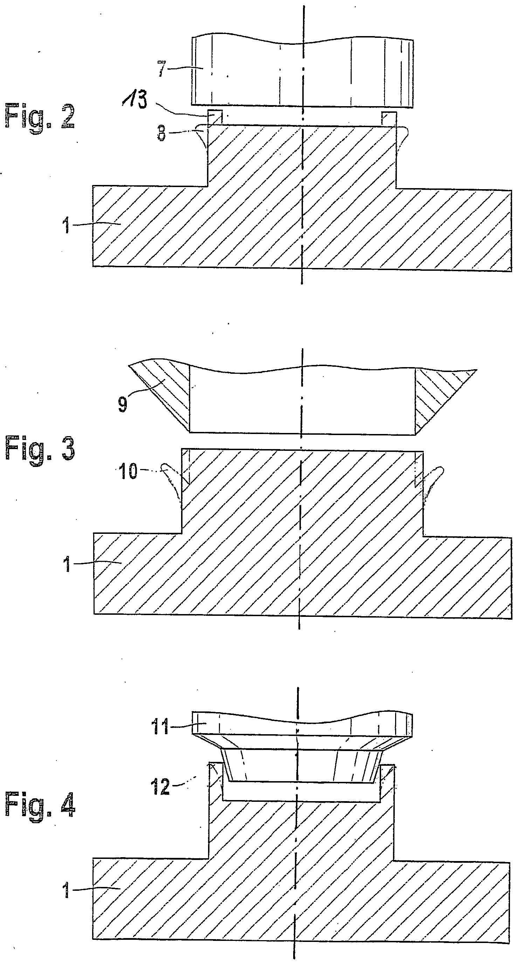

In den Druckschriften DE-OS 43 41 269 (D1) und DE-P 195 49 202 (D2) werden die grundsätzlichen Konstruktionsmerkmale von mit Kunststoff ummantelten Einpressdioden beschrieben. In den Figuren 3 und 4 ist dieser Stand der Technik aufgezeigt. Eingesetzt werden solche Einpressdioden beispielsweise in der Gleichrichterbrücke von Drehstomgeneratoren in Kraftfahrzeugen. Damit bei falschem Anschluss der Fahrzeugbatterie keine Beschädigungen auftreten, wird ein geeigneter Verpolschutz benötigt. Ein Verpolschutzelement, das geeignet ist für den Einsatz in Drehstomgeneratoren in Kraftfahrzeugen, ist aus der Druckschrift DE-P 100 05 183 (D3) bekannt.

Die EP 0 034 208 A1 beschreibt eine Leistungsdiode mit zwei bolzenartigen Anschlussleitern die heute als Kopfdraht und Sockel bezeichnet werden. Zwischen diesen beiden Anschlussbolzen liegt ein Halbleiterchip der die eigentliche Diodenfunktion bewirkt. Eine Kunstharzmasse überdeckt Teile der beiden Anschlussleiter und den Rand des Halbleiterchips. Die Kunstharzmasse ist in eine Kunststoffhülse eingegossen, die fest mit dem Sockel verbunden ist, wodurch ein Fixieren der Kunststoffmasse unter allen Bedingungen erreicht wird.

Die EP 0 936 670 A2 zeigt Leistungshalbleitermodule, bei denen der Laststrom oberhalb einer Temperaturschwelle irreversibel unterbrochen wird. Dazu sind Unterbrechungsmittel vorgesehen, die beispielweise innerhalb eines Gehäuses angeordnet sind bzw. Bestandteil des Gehäuses sind. Diese Mittel sind aus einem Material, das bei zunehmender Temperatur eine volumenerweiternde und/oder oxidierende und/oder eine explodierende Charakteristik aufweisen und dafür sorgen, das bei Erreichen einer Temperaturschwelle der Stromfluss beendet wird.

Aus der Druckschrift JP08078611, Patent Abstract of Japan, Band 1996, No. 07 vom 31.07.1996 ist eine Halbleiteranordnung bekannt, mit einem Überstromschutz.

Dieser Überstromschutz besteht aus zwei unterschiedlichen Mold-Bereichen mit unterschiedlichen Temperaturkoeffizienten. Bei Überstrom wird die Verbindung zwischen dem Halbleiterchip und den Anschlüssen durch entstehende mechanische Spannungen unterbrochen.

### Vorteile der Erfindung

Die erfindungsgemäße Lösung ergibt eine mit Kunststoff ummantelte Einpressdiode, die sicher und zuverlässig über einen weiten Temperaturbereich arbeitet bzw. in einem solchen weiten Temperaturbereich eingesetzt werden kann. Im üblichen Betriebstemperaturbereich (ca. 230°C) der Diode ist eine sichere Verklammerung zwischen Kopfdraht und Sockel gewährleistet und bei Übertemperatur (ca. 400°C), die beispielsweise bei einem verpolten Anschluss der Batterie auftreten kann, löst sich die Verklammerung und bewirkt eine Unterbrechung des Stromflusses, wodurch eine weitere Erhitzung und schlimmstenfalls eine Entzündung des Kunststoffs zuverlässig vermieden wird.

Erzielt werden diese Vorteile durch die im Anspruch 1 angegebenen Merkmale, nach denen eine Einpressdiode, bei der ein den pn-Übergang bildender Chip über Lotschichten mit einem Kopfdraht und einem Sockel verbunden ist so ausgestaltet ist, dass wenigstens im Bereich des Chips ein Kunststoffmantel und eine Hülse eine Verbindung bilden, die als Verklammerung wirkt, wobei wenigstens ein Teil eine vorgebbare Ausbuchtung hat, die in den Kunststoffmantel ragt und im Normalzustand eine feste Verbindung bildet. Bei Überhitzung, die sich beispielsweise bei einer Verpolung, bzw. bei verpoltem Anschluss des elektrischen Bauelements an eine Spannungsquelle einstellt, wird der Kunststoff weich und die Verklammerung löst sich, wodurch der Stromfluss durch die Einpressdiode unterbrochen wird. Die Lösung der Verklammerung wird noch verstärkt, wenn Kräfte wirken, die bei aufgeweichtem Kunststoff ein Auseinanderziehen bzw. Auseinanderdrücken der beiden Teile bewirken. Solche Kräfte entstehen in vorteilhafter Weise durch die temperaturabhängige Ausdehnung des Kunststoffs.

Weitere Vorteile der Erfindung ergeben die in den Unteransprüchen aufgeführten Maßnahmen. Dabei ist besonders vorteilhaft, dass einfache mechanisch konstruktive Merkmale zu einer sicheren Fixierung bei gleichzeitigem Verpolschutz führen. Dies gilt insbesondere für den vorteilhaften Einsatz des elektrischen Bauelementes, beispielsweise einer Diode bei einer Gleichrichteranordnung in einem Kraftfahrzeug. Tritt ein Kurzschluss auf, beispielsweise durch falschen Anschluss der Batterie, wird der Stromfluss durch die Dioden des Gleichrichters unterbrochen und die übermäßige Überhitzung gefährdeter Bauteile verhindert, so dass brennbare Teile des Generators oder der Zuleitungen sich nicht entzünden können. Die Wahl eines geeigneten Kunststoffs oder eines sonstigen Stoffs, der bei bestimmten Temperaturen aufweicht ermöglicht es, die Lösung der Verklammerung innerhalb einer gewissen Temperaturspanne einzustellen.

### Zeichnung

Ausführungsbeispiele der Erfindung sind in den Figuren der Zeichnung dargestellt und werden in der Beschreibung näher erläutert. Im einzelnen zeigt Figur 1a eine bekannte Einpressdiode und Figur 1b ein Ausführungsbeispiel der Erfindung. In den Figuren 1 c und 1d sind Kombinationen der Einpressdioden nach Figur 1a und 1b dargestellt, die weitere Ausführungsbeispiele der Erfindung darstellen. In Figur 2 ist ein Beispiel für die Herstellung eines erfindungsgemäßen elektrischen Bauteils dargestellt und die Figuren 3 und 4 zeigen Beispiele für die Herstellung bekannter Einpressdioden oder von Teilen für erfindungsgemäße Ausführungsformen.

### Beschreibung

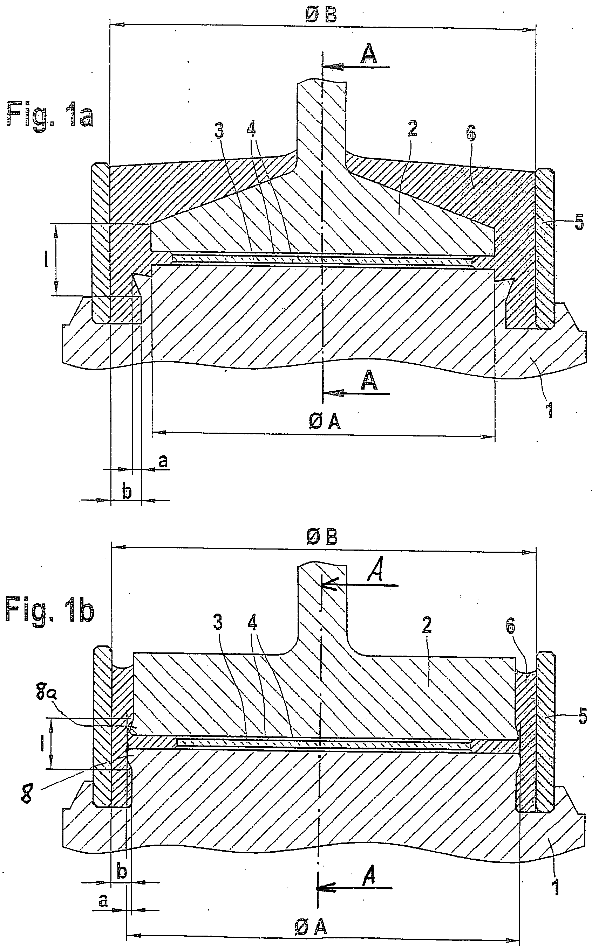

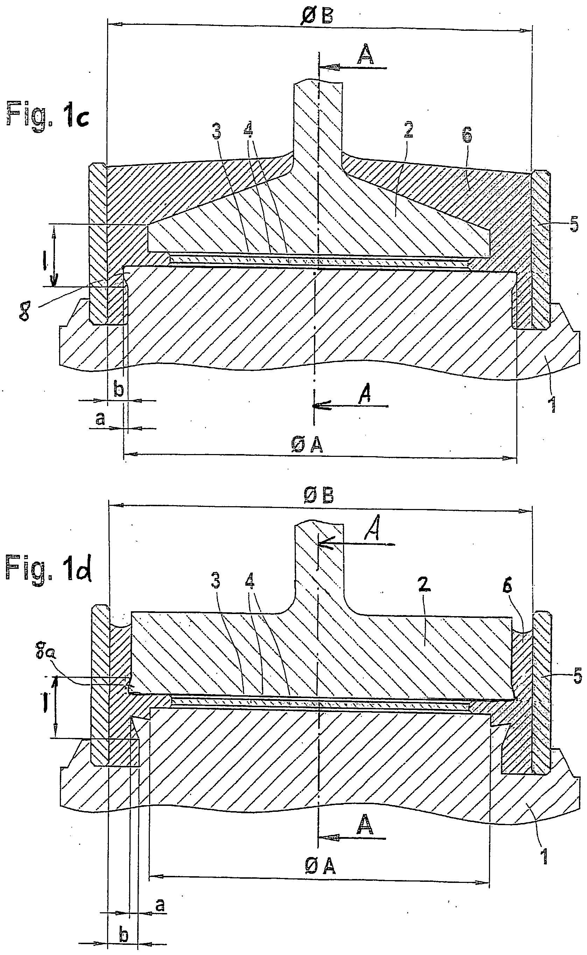

Figur 1 vergleicht das erfindungsgemäße elektrische Bauteil mit der internen Bezeichnung ED11 mit dem Bauteil mit einem Gehäusetyp mit der internen Bezeichnung ED10, das bereits in der DE-P 195 49 202 beschrieben wird. In Figur 1b ist dazu ein Ausführungsbeispiel der Erfindung dargestellt und in Figur 1a die bekannte Lösung, Das elektrische Bauteil ist dabei jeweils eine Diode.

Die Diode setzt sich zusammen aus einem Sockel 1, der auch als erstes Teil bezeichnet wird und einem Kopfdraht 2, auch als zweites Teil bezeichnet, der bei der bekannten Diode teilweise kegelförmig ausgestaltet ist und bei der erfindungsgemäßen Lösung teilweise zylinderförmig. Ein Chip 3, das den eigentlichen pn-Übergang bildet, ist mittels zweier Lotschichten 4 und 5 mit dem Sockel 1 und dem Kopfdraht 2 mechanisch und elektrisch verbunden. Eine Schutzhülse 5 umgibt zumindest den Übergangsbereich zwischen dem Sockel 1 und dem Kopfdraht 2, in dem sich auch der Chip 3 befindet und bildet somit zusammen mit dem Sockel 1 eine Art Gehäuse. Der Raum zwischen der Schutzhülse 5 und den übrigen Teilen ist mit einem Kunststoff 6 ausgefüllt.

Der Sockel 1 weist eine Hinterschneidung 8 auf, der Kopfdraht eine Hinterschneidung 8a, die beide in den Kunststoff 6 ragen und bei festem Kunststoff eine Fixierung bewirken. Der Sockel 1 und der Kopfdraht 2 sind also miteinander verklammert. Das elektrische Bauelement nach Figur 1b ist bei üblichen Temperaturen eine fixierte Einheit, die auch bei Kräften, die üblicherweise zwischen dem Sockel 1 und dem Kopfdraht 2 wirken und diese auseinanderziehen würden, stabil ist. Bei der bekannten Diode nach Figur 1a weist dagegen lediglich der Sockel 1 eine Ausragung 10 auf, die in den Kunststoff 6 ragt.

Neben dem Sockel 1 kann auch der Kopfdraht 2 so ausgestaltet werden, dass er eine eigene Hinterschneidung 8a aufweist, die in den Kunststoff 6 ragt.

Bei verpoltem Anschluss des elektrischen Bauteils fließt zwischen den beiden Teilen über den dann leitenden Chip ein hoher Strom, der zu einer starken Erwärmung führt. Da der Kunststoff bei höheren Temperaturen wie sie bei einer Verpolung auftreten, ebenfalls heiß wird wird er auch weich und dehnt sich mit steigender Temperatur auch aus. Durch die Ausdehnung des sich im Bereich zwischen Kopfdraht und Sockel befindlichen Kunststoffs entstehen Kräfte, die Kopfdraht und Sockel auseinander drücken. Da aber gleichzeitig der Kunststoff bei der bei Verpolung herrschenden hohen Temperatur von bis zu 400°C weich wird, löst sich die feste Klammerung zwischen den Teilen und der Stromfluss zwischen den beiden Teilen durch den im Verpolungsfall leitenden Chip wird unterbrochen, wodurch sich der gewünschte Verpolschutz einstellt.

In den Figuren 1c und 1d sind zwei weitere erfindungsgemäße Ausführungsformen dargestellt, die Kombinationen der in den Figuren 1a und 1b dargestellten Lösungen darstellen. Obwohl die Ausführungsformen der erfindungsgemäßen Dioden rotationssymmetrisch sind, sind auch Lösungen, die nicht rotationssymmetrisch sind, denkbar. Wesentlich ist, dass wenigstens ein Teil, entweder der Sockel oder der Kopfdraht wenigstens eine vorgebbare Ausbuchtung oder Hinterschneidung aufweist, die in den Kunststoff ragt und bei festem Kunststoff eine feste Verbindung bildet, die bei weichem, insbesondere flüssigem Kunststoff, also bei hohen Temperaturen gelöst wird.

Die erfindungsgemäße Einpressdiode unterscheidet sich von den in der DE-OS 43 41 269 oder DE-P 195 49 202 beschriebenen Dioden auch durch die Art und die Herstellung der Hinterschneidung 8 am Diodensockel 1 sowie gegebenenfalls am Kopfdraht 2. In den Figuren 2, 3 und 4 sind nähere Angaben zur Herstellung solcher Dioden gemacht.

In Figur 2 ist dargestellt, wie mittels eines Stempels 7 sowie gegebenenfalls mittels weiterer Bearbeitung eine Hinterschneidung 8 am Sockel 1 hergestellt werden kann. Die Hinterschneidung 8 soll dabei als umlaufender Kragen ausgestaltet werden. Der Stempel 7 bringt einen Druck auf den beispielsweise rotationssymmetrischen Bereich 13 und verformt diesen. Durch diese Verformung wird die nach dem Zusammenbau dem Chip zugewandte Oberfläche des Sockels nicht verkleinert. In einem zusätzlichen zweiten Arbeitsschritt wird die Hinterschneidung planiert. Dadurch entsteht die in Figur 1b dargestellte Hinterschneidung 8 am Diodensockel, die zusammen mit der sich anschließenden Oberfläche des Sockels eine optimal große Auflagefläche bilden, auf die der Chip aufgebracht werden kann.

Im Gegensatz dazu wird bei dem aus der DE-P 195 49 202 bekannten Fertigungsverfahren, das in Figur 3 skizziert ist, mit einem zylindrischen Schälmesser 9 ein Teil des Sockel 1 abgeschält und zur Ausragung 10 geformt, die einen umlaufenden Kragen bildet. Dabei verringert sich die Oberfläche des Sockels 1, während sich bei der erfindungsgemäßen Lösung nach Figur 2 die Oberfläche des Sockels 1 und damit die Chipauflagefläche nicht verringert.

In Figur 4 ist eine weitere Möglichkeit für die Herstellung eines Kragens für den Sockel einer Einpressdiode dargestellt, die aus der DE-43 41 269 bekannt ist. Dabei wird für die Herstellung des Kragens des Sockels eine rotationssymmetrische Verlängerung 12 des Sockels 1 benutzt, die mittels eines Formwerkzeugs 11 in eine gewünschte Form gebracht wird.

Bei gleichem Maß b wird der Durchmesser A der Chipauflagefläche maximal. Das Gehäuse, das gebildet wird durch den Sockel 1, die Hülse 5, den Kunststoff 6 und den Kopfdraht 2 kann einen größeren Siliziumchip aufnehmen als das bekannte Gehäuse und ist daher für höhere Ströme geeignet. In einer Ausführungsform mit Durchmesser B = 10,3 mm, wobei B der Innendurchmesser der Plastikhülse ist, kann der Durchmesser A der Chipauflagefläche bei einem Sockel nach der DE-P 195 49 202 maximal 8 mm betragen, bei der erfindungsgemäßen Lösung dagegen maximal 9,2 mm.

Dasselbe gilt auch für den Vergleich mit der Ausführung nach der DE-OS 43 41 269. Die Wandstärke des Kragens verbraucht bei dieser bekannten Lösung immer einen Teil der Chipauflagefläche, so dass diese immer kleiner sein wird, als im Fall der erfindungsgemäßen Lösung.

Durch die Höhe und die Wandstärke des Kragens kann bei der Erfindungsgemäßen Lösung das Maß a der Hinterschneidung 8 eingestellt werden. Dabei sollte a so gewählt werden, dass bei der normalen Betriebstemperatur der Diode von z.B. maximal 230°C der Kunststoff 6 den Kopfdraht 2 und den Sockel 1 ausreichend verklammert. Bei versehentlicher Batterieverpolung im Kraftfahrzeug, wenn der Pluspol der Batterie an der Anode der Diode angeschlossen wird und der Minuspol an der Kathode soll die Diode den Stromfluss unterbrechen, bevor sich durch Überhitzung die Kunststoffisolation des Generators oder des Batteriekabels entzündet. Diese Forderung kann realisiert werden, wenn die Verklammerung in der Diode bei maximal 400°C freigegeben wird, durch Aufweichen des verwendeten Kunststoffs 6 und dann auftretendem Auseinanderziehen von Sockel und Kopfdraht 2.

Bei einem konkreten Beispiel beträgt die Wärmeausdehnung des Kunststoffes der Diode 30 ppm/K. Mit der Wärmeausdehnung von Kupfer, dem Werkstoff des Diodensockels, errechnet sich daraus eine maximale Hinterschneidung a von ca. 0,05mm. Solche geringen Hinterschneidungen sind mit Methoden, wie sie in den Druckschriften DE-OS 43 41 269 oder DE-P 195 49 202 beschrieben werden, nicht herstellbar. Typische Werte liegen bei den bekannten Lösungen bei 0,2 mm.

Die spezielle Ausgestaltung des Kopfdrahts nach Figur 1 b unterstützt die Öffnung der Diode bei Batterieverpolung, wenn auch hier die Hinterschneidung a 0,05mm nicht überschreitet. Als weiterer Vorteil dieses Kopfdrahts ist anzuführen, dass das Maß 1 minimal wird im Vergleich zu den bekannten Lösungen. Wie in der DE-OS 43 41 269 erläutert wird, kann die Kunststoffummantelung der Diode umso mehr Zugbelastung aufnehmen, je kleiner 1 wird. Typische Werte der bekannten Gehäuse liegen bei 1 = 1mm, bei der erfindungsgemäßen Lösung bei 1 = 0,5 mm.

Die Erfindung beinhaltet letztendlich in vorteilhaftester Ausgestaltung eine Einpressdiode für hohe Ströme mit eingebautem Verpolschutz, da die Verklammerung bei einer durch Verpolung verursachten Überhitzung selbständig gelöst wird.

## Patentansprüche

1. Einpressdiode, mit einem Chip, der über Lotschichten mit einem ersten Teil, das einen Diodensockel bildet und einem zweiten Teil, das einen Kopfdraht bildet, verbindbar ist und wenigstens im Bereich des Chips eine Kunststoffummantelung und eine Hülse aufweist, die die mechanische Verbindung als Verklammerung bilden und wenigstens ein Teil eine vorgebbare Ausbuchtung oder Hinterschneidung aufweist, die in die Kunststoffummantelung ragt, **dadurch gekennzeichnet, dass** die Kunststoffummantelung aus einem Kunststoff (6) ist, der in einem ersten Temperaturbereich fest und in einem höheren Temperaturbereich weich ist,
dass die Wärmeausdehnung des Kunststoffes 30 ppm/K beträgt,
dass der Werkstoff des Diodensockels Kupfer ist und dass die Hinterschneidung (8) maximal 0,05 mm beträgt, so dass bei festem Kunststoff (6) eine Verklammerung zwischen dem Diodensockel (1) und dem Kopfdraht (2) gewährleistet ist und bei weichem Kunststoff (6) eine Lösung der Verklammerung auftritt und die Verbindung zwischen den beiden Teilen Diodensockel (1) und Kopfdraht (2) gelöst wird.

2. Einpressdiode nach Anspruch 1, **dadurch gekennzeichnet, dass** beide Teile Diodensockel (1) und Kopfdraht (2) eine Ausbuchtung oder Hinterschneidung (8) aufweisen.

3. Einpressdiode, nach Anspruch 1 oder 2, **dadurch gekennzeichnet, dass** die Ausbuchtung oder Hinterschneidung (8) rotationssymmetrisch ist.

4. Einpressdiode nach einem der vorhergehenden Ansprüche, **dadurch gekennzeichnet, dass** sie Bestandteil einer Gleichrichteranordnung, insbesondere bei einem Generator ist.

5. Einpressdiode nach einem der vorhergehenden Ansprüche, **dadurch gekennzeichnet, dass** der erste Temperaturbereich bis maximal 400°C reicht.

6. Einpressdiode nach Anspruch 5, **dadurch gekennzeichnet dass** bei Lösung der Verklammerung die elektrische Verbindung zwischen dem ersten Teil Diodensockel (1), dem Chip (3) und dem zweiten Teil Kopfdraht (2) unterbrochen ist.

7. Verfahren zur Herstellung einer Einpressdiode nach einem der vorhergehenden Ansprüche, **dadurch gekennzeichnet, dass** am Diodensockel (1) eine Hinterschneidung (8) erzeugt wird, indem zunächst ein Bereich (13) des Diodensockels (1) unter Aufbringung eines Drucks verformt wird und anschließend ein Planarisierung durchgeführt wird.

8. Verfahren zur Herstellung einer Einpressdiode nach Anspruch 7, **dadurch gekennzeichnet, dass** der Druck mittels eines Stempels erzeugt wird.

9. Verfahren zur Herstellung einer Einpressdiode nach Anspruch 7, **dadurch gekennzeichnet, dass** die Hinterschneidung (8) ausgehend von einem umlaufender Kragen oder Wulst erzeugt wird und rotationssymmetrisch ist.

## Claims

1. Insertion diode comprising a chip which can be connected via solder layers to a first part, which forms a diode base, and a second part, which forms a head wire, and has a plastic jacket and a sleeve, at least in the region of the chip, which form the mechanical connection as a clamp fitting, and at least one part has a predefined projection or undercut which projects into the plastic jacket, **characterized in that** the plastic jacket is made of a plastic (6) which is solid in a first temperature range and is soft in a higher temperature range, **in that** the thermal expansion of the plastic is 30 ppm/K, **in that** the material of the diode base is copper, and **in that** the undercut (8) is at most 0.05 mm, so that when the plastic (6) is solid, clamping between the diode base (1) and the head wire (2) is ensured and, when the plastic (6) is soft, loosening of the clamping occurs and the connection between the two parts, diode base (1) and head wire (2), is released.

2. Insertion diode according to Claim 1, **characterized in that** both parts, diode base (1) and head wire (2), have a projection or undercut (8).

3. Insertion diode according to Claim 1 or 2, **characterized in that** the projection or undercut (8) is rotationally symmetrical.

4. Insertion diode according to one of the preceding claims, **characterized in that** it is a constituent part of a rectifier arrangement, in particular in a generator.

5. Insertion diode according to one of the preceding claims, **characterized in that** the first temperature range reaches as far as a maximum of 400° C.

6. Insertion diode according to Claim 5, **characterized in that** when the clamping is loosened, the electrical connection between the first part, diode base (1), the chip (3) and the second part, head wire (2), is interrupted.

7. Method for producing an insertion diode according to one of the preceding claims, **characterized in that** an undercut (8) is produced on the diode base (1) **in that**, firstly, an area (13) of the diode base (1) is deformed by applying a pressure and then planarization is carried out.

8. Method for producing an insertion diode according to Claim 7, **characterized in that** the pressure is produced by means of a punch.

9. Method for producing an insertion diode according to Claim 7, **characterized in that** the undercut (8) is produced by starting from a circumferential collar or bead and is rotationally symmetrical.

## Revendications

1. Diode à enfoncer, avec une puce qui peut être assemblée par l'intermédiaire de couches de brasage avec une première partie, qui forme un socle de diode et une deuxième partie qui forme un fil métallique de tête et qui comporte au moins dans la zone de la puce une enveloppe en matière plastique et une douille, qui forment l'assemblage mécanique en tant que cramponnage et au moins une partie comporte une indentation ou contre-dépouille prédéfinissable, qui saillit dans l'enveloppe en matière plastique, **caractérisée en ce que** l'enveloppe en matière plastique est en une matière plastique (6) qui dans un premier ordre de températures est rigide et dans un ordre de températures plus élevé est souple,
**en ce que** la dilatation thermique de la matière plastique est de 30 ppm/K,
**en ce que** la matière du socle de diode est du cuivre et **en ce que** la contre-dépouille (8) est d'un maximum de 0,05 mm, de sorte que lorsque la matière plastique (6) est rigide, un cramponnage entre le socle de diode (1) et le fil métallique (2) de tête soit assuré et lorsque la matière plastique (6) est souple, une désolidarisation du cramponnage intervienne et l'assemblage entre les deux parties socle de diode (1) et fil métallique (2) de tête soit désolidarisé.

2. Diode à enfoncer selon la revendication 1, **caractérisée en ce que** les deux parties socle de diode (1) et fil métallique (2) de tête comportent une indentation ou contre-dépouille (8).

3. Diode à enfoncer selon la revendication 1 ou la revendication 2, **caractérisée en ce que** l'indentation ou la contre-dépouille (8) est symétrique en rotation.

4. Diode à enfoncer selon l'une quelconque des revendications précédentes, **caractérisée en ce qu'**elle est un élément d'un agencement de redresseur, notamment sur un générateur.

5. Diode à enfoncer selon l'une quelconque des revendications précédentes, **caractérisée en ce que** le premier ordre de température va jusqu'à un maximum de 400°C.

6. Diode à enfoncer selon la revendication 5, **caractérisée en ce que** lors de la désolidarisation du cramponnage, la connexion électrique entre la première partie socle de diode (1), la puce (3) et la deuxième partie fil métallique (2) de tête est interrompue.

7. Procédé destiné à fabriquer une diode à enfoncer selon l'une quelconque des revendications précédentes, **caractérisé en ce que** sur le socle de diode (1), on créé une contre-dépouille (8) **en ce que** d'abord on déforme une zone (13) du socle de diode (1) en appliquant une pression et dans la suite, on procède à une planarisation.

8. Procédé destiné à fabriquer une diode à enfoncer selon la revendication 7, **caractérisé en ce qu'**on créé la pression à l'aide d'un poinçon.

9. Procédé destiné à fabriquer une diode à enfoncer selon la revendication 7, **caractérisé en ce qu'**on créé la contre-dépouille (8) en partant d'un collet ou bourrelet périphérique et qu'elle est symétrique en rotation.
